# EUROPEAN PATENT SPECIFICATION

(11) **EP 3 392 045 B1**
(45) Date of publication and mention of the grant of the patent: **05.07.2023**
(21) Application number: 16874314.4
(22) Date of filing: 13.05.2016
(51) Int. Cl.: B41J 2/175, H05K 1/11, G03G 15/00, G03G 21/18, H01R 12/71, H01R 13/22, H01L 23/482

(54) **INKJET PRINTER CHIP AND INKJET PRINTER**
TINTENSTRAHLDRUCKERCHIP UND TINTENSTRAHLDRUCKER
PUCE D'IMPRIMANTE À JET D'ENCRE ET IMPRIMANTE À JET D'ENCRE

(30) Priority: 14.12.2015 CN 201510930940; 14.12.2015 CN 201521039615 U
(43) Date of publication of application: 24.10.2018
(73) Proprietor: Zhuhai Ninestar Management Co., Ltd., Zhuhai, Guangdong 519060 (CN)
(72) Inventor: CHEN, Weijian, Zhuhai Guangdong 519060 (CN)
(74) Representative: Dr. Gassner & Partner mbB
(86) International application number: PCT/CN2016/082066
(87) International publication number: WO 2017/101249

(56) References cited:
- WO-A1-2014/094407
- CN-A- 103 101 317
- CN-A- 104 378 913
- CN-U- 201 856 452
- CN-U- 201 856 452
- CN-U- 202 862 815
- CN-U- 203 282 858
- CN-U- 203 282 859
- CN-Y- 201 086 450
- JP-A- 2012 158 180
- US-A1- 2015 273 846

## Description

### TECHNICAL FIELD

The present invention relates to a field of inkjet printing technology, and in particular, to a chip of inkjet printer and an inkjet printer.

### BACKGROUND

There are many types of chips for inkjet printer and ink cartridge. The chip for inkjet printer is used to store information such as manufacturer information, ink amount information, ink cartridge type information, ink color information, etc. The chip for inkjet printer plays a decisive role in the normal working of the inkjet printer.

Among them, Chinese Patent No. 201110375124.4 discloses a board (chip) 200. Referring to FIG. 1, it can be seen that the board 200 includes terminals 210-290 thereon, and the terminals 210-290 are divided into two rows, each terminal has its own contact portion cp, and the contact portion cp is a position that is in contact with a contact mechanism (needle) (not shown).

Japanese Application No. 2012066865 (JP 2012-158180 A) discloses a circuit board 200, where the circuit board 200 attached to the printing material container includes a terminal group that is connected to a connector terminal group on the side of the printing apparatus body when the printing material container is mounted in the printing apparatus body, and an overcoat 220 for the circuit board 200.

Chinese Application No. 201020599870.2 (CN 201856452 U) discloses an ink box chip and an ink box. The ink box chip comprises a substrate. The substrate is provided with a first surface and a second surface which are arranged back to back. An electronic module is arranged on the substrate, wherein the substrate is provided with a plurality of grooves; the inner walls of the grooves are provided with conductive components; and the conductive components are electrically connected with the electronic module.

However, in the process of implementing the present technical solution, the inventor found the following problems in the prior art:
At present, the miniaturized printers have gained increasingly greater attention by the companies and the households. As a result, the chip size is becoming smaller and smaller, and the size of each terminal is getting smaller and smaller. Therefore, looseness of the printer-side terminals holder and printer-side terminals is easy to occur after a period of time use, and there may be some deviations from the contact positions between the chip and the printer-side terminals holder and printer-side terminals, compared with the normal contact positions. In this case, it is easily to appear that the power supply terminal on the chip has been contacted with the corresponding printer-side terminal on the printer, but the attachment detection terminal cannot be properly connected, resulting in the printer cannot identify the chip or damage condition of the chip, the printer;

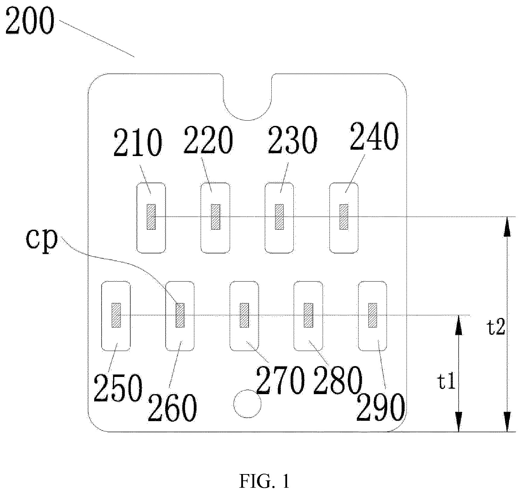

In addition, since the ink cartridge in the printer is a consumable product, it needs to be replaced after use. The board is located on the ink cartridge, and the printer has a printer-side terminal electrically connected to the board. During the ink cartridge installation process, the printer-side terminals and the board need rub against each other until the attachment is in place. As shown in FIG. 1, the rubbing distance between the first row of printer-side terminals and the board is 11, and the rubbing distance between the second row of printer-side terminals and the board is t2. After the printer is used for a period time, and each of the exhausted ink cartridges is replaced, printer-side terminals is rubbed many times, it will lead to the wear of the ridge-shaped peak contact portion of the printer-side terminals, which will result in imperfect contacts; in particular for the printer-side terminal corresponding to the power supply terminal, if the printer-side terminal corresponding to the power supply terminal is wore, it will cause the power supply of the board to become unstable and affect the electrical transmission between the board and the printer-side terminals.

### SUMMARY

The invention provides a chip of inkjet printer and an inkjet printer, which can effectively overcome the existing situations in the prior art that the power supply terminal on the chip have been contacted with the corresponding printer-side terminal on the printer, but the attachment detection terminal cannot be properly connected, resulting in the printer cannot identify the chip or damage condition of the chip, the printer, and at the same time, the technical problem of the wear of the printer-side terminal can be solved.

An aspect of the present invention is to provide a chip of inkjet printer, comprising at least a hollow portion, a memory, two attachment detection terminals, and a power supply terminal connected to the memory. Attachment detection contact portions for making an electrical contact with corresponding printer-side terminals of the printer are formed on the attachment detection terminals. A power supply contact portion for making an electrical contact with a corresponding printer-side terminal of the printer is formed on the power supply terminal. The hollow portion is formed below the power supply terminal. The power supply contact portion is provided on an end surface of the hollow portion. The attachment detection contact portions are provided on both sides of the hollow portion. The distance between the attachment detection contact portion and a front end of the chip is less than the distance between the power supply contact portion and the front end of the chip, in an installation direction of installing the chip to the printer.

The chip for inkjet printer as described above, the power supply contact portion is provided on a rear end surface of the hollow portion, in the installation direction of installing the chip to the printer.

The chip for inkjet printer as described above, the distance between the attachment detection contact portions and the front end of the chip is less than the distance between the power supply terminal and the front end of the chip, in the installation direction of installing the chip to the printer.

The chip for inkjet printer as described above, the distance between the attachment detection terminals and a front end of the chip is less than the distance between the power supply terminal and the front end of the chip, in the installation direction of installing the chip to the printer.

The chip for inkjet printer as described above, further comprising: a ground terminal and a data terminal connected to the memory, a ground contact portion for making electrical contact with a corresponding printer-side terminal of the printer is formed on the ground terminal, and a data contact portion for making electrical contact with a corresponding printer-side terminal of the printer is formed on the data terminal. At least one of the ground terminal and the data terminal is provided on the rear end surface of the hollow portion, in the installation direction of installing the chip to the printer.

The chip for inkjet printer as described above, when both of the ground terminal and the data terminal are provided on the rear end surface of the hollow portion, the area, where the power supply contact portion, the ground contact portion and the data contact portion are located, is located at the rear ends of the area where the two attachment detection contact portions are located, in the installation direction of installing the chip to the printer, when both of the ground terminal and the data terminal are provided on the rear end surface of the hollow portion.

The chip for inkjet printer as described above, the area, where the power supply terminal, the ground terminal and the data terminal are located, is located at the rear ends of the area where the two attachment detection terminals are located, in the installation direction of installing the chip to the printer.

The chip for inkjet printer as described above, further comprising at least one control terminal connected with the memory, a control contact portion for making electrical contact with a corresponding printer-side terminal of the printer is formed on each control terminal, and the distance between each control contact portion and the front end of the chip is more than the distance between the power supply contact portion and the front end of the chip.

The chip for inkjet printer as described above, a first short circuit detection terminal and a second short circuit detection terminal located between the two attachment detection terminals are further provided on the chip, both the power supply terminal and the at least one control terminal are provided between the first short circuit detection terminal and the second short circuit detection terminal.

The chip for inkjet printer as described above, respective contact portions of all terminals on the chip are arranged in at least three lines from the front end to the rear end of the chip, and the respective contact portions of all terminals arranged in at least three is provided staggered in an installation direction of installing the chip to the printer.

The chip for inkjet printer as described above, in the at least three lines, the front two lines from the front end side to the rear end side in the installation direction are the first line and the second line respectively, and the attachment detection contact portions are located in the first line, and the power supply contact portion is located in the second line.

The chip for inkjet printer as described above, positioning portions recessed toward the inside of the chip are formed on the chip, the positioning portions are located on both sides of rear end of the plurality of control terminals.

The chip for inkjet printer as described above, the hollow portion is a closed structure formed inside the chip, or the hollow portion is an opening structure formed at lower end of the chip.

The chip for inkjet printer as described above, the attachment detection contact portions are provided on both sides of the hollow portion.

Another aspect of the present invention is to provide an inkjet printer comprising the chip for inkjet printer above.

A chip of inkjet printer and an inkjet printer provided by the invention effectively avoids the existing situations in the prior art that the power supply terminal on the chip has been contacted with the corresponding printer-side terminal on the printer, but the attachment detection terminal cannot be properly connected, resulting in the printer cannot identify the chip or damage condition of the chip, the printer, ensuring the stability and reliability of use of the chip, through providing the distance between the attachment detection contact portion in the first line and a front end of the chip less than the distance between the power supply contact portion in the second line and the front end of the chip, i.e. so that the power supply contact portion is located at the upper end of the two attachment detection contact portions. In addition, in the case of the hollow portion provided, the contact stroke between the printer-side terminal and the chip is effectively reduced, the wear of the printer-side terminal is reduced, and the problems of the imperfect contact and the electrical transmission between the chip and the printer caused by the wear of the printer-side terminal are avoided, which improves the stability and reliability of the use of the chip, and is beneficial to the promotion and application of the market.

### BRIEF DESCRIPTION OF THE DRAWINGS

FIG. 1 is a schematic structural diagram of a chip of inkjet printer in the prior art;
FIG. 2 is a schematic structural diagram of a chip of inkjet printer according to an embodiment of the present invention;
FIG. 3 is a rear view of the chip for inkjet printer shown in FIG. 2;
FIG. 4 is a schematic stereoscopic structural diagram of the chip for inkjet printer shown in FIG. 2;
FIG. 5 is a schematic diagram of the principle of the installation process of the chip for inkjet printer shown in FIG. 2;
FIG. 6 is a schematic structural diagram of a chip of inkjet printer according to a further embodiment of the present invention;
FIG. 7 is a schematic structural diagram one of a chip of inkjet printer according to an another embodiment of the present invention;
FIG. 8 is a schematic structural diagram two of a chip of inkjet printer according to an another embodiment of the present invention;
FIG. 9 is a schematic structural diagram of a chip of inkjet printer according to a further embodiment of the present invention;
FIG. 10 is a schematic structural diagram of a chip of inkjet printer according to a further embodiment of the present invention;
FIG. 11 is a schematic structural diagram of a chip of inkjet printer according to a further embodiment of the present invention;
FIG. 12 is a rear view of the chip for inkjet printer shown in FIG. 11;
FIG. 13 is a schematic structural diagram of a chip of inkjet printer according to a further embodiment of the present invention;
FIG. 14 is a schematic structural diagram of a chip of inkjet printer according to a further embodiment of the present invention;
FIG. 15 is a schematic structural diagram one of an ink cartridge according to an embodiment of the present invention;
FIG. 16 is a schematic structural diagram two of an ink cartridge according to an embodiment of the present invention;
FIG. 17 is a schematic stereoscopic structural diagram of an ink cartridge according to an embodiment of the present invention;
FIG. 18 is a schematic structural diagram of an ink cartridge installation portion according to an embodiment of the present invention;
FIG. 19 is a schematic structural diagram of the first printer-side terminal according to an embodiment of the present invention;
FIG. 20 is a schematic structural diagram of a separate connection structure of a chip of inkjet printer and a printer-side terminal according to an embodiment of the present invention.
FIG. 21 is a schematic structural diagram of a connection structure of a chip of inkjet printer and a printer-side terminal according to an embodiment of the present invention.

In the figures:
200: board (chip);
cp: contact portion;
111: first series-connected terminal;
113: clock terminal;
115: first attachment detection terminal;
117: ground terminal;
119: second attachment detection terminal;
112c: reset contact portion;
114c: second series-connected contact portion;
116c: power supply contact portion;
118c: data contact portion;
121: first short circuit detection terminal;
131: first positioning portion;
133: hollow portion;
133b: rear end surface;
134: first chamfer angle;
136: third chamfer angle;
141: memory;
20: ink cartridge;
210-290: terminal;
11: chip;
112: reset terminal;
114: second series-connected terminal;
116: power supply terminal;
118: data terminal;
111c: first series-connected contact portion;
113c: clock contact portion;
115c: first attachment detection contact portion;
117c: ground contact portion;
119c: second attachment detection contact portion;
122: second short circuit detection terminal;
132: second positioning portion;
133a: side end surface;
133c: front end surface;
135: second chamfer angle;
137: fourth chamfer angle;
142: electrical element;
20a: first face;
20b: second face;
20d: fourth face;
22: housing;
231: first stuck position;
25: second stuck position;
31: ink supply needle;
32a: first printer-side terminal
321: first contact head;
321b: peak portion;
323: connection portion;
20c: third face;
21: ink outlet;
23: handle;
24: chip holder
30: ink cartridge attachment portion;
32: printer-side terminal;
32f: sixth printer-side terminal;
321a: slope portion
322: second contact head;
33: print head.

### DETAILED DESCRIPTION OF THE EMBODIMENTS

To make the objectives, technical solutions, and advantages of the present invention more clear, the technical solutions in the embodiments of the present invention will be described below clearly and completely with reference to the accompanying drawings in the embodiments of the present invention. Obviously, the described embodiments merely a part of the embodiments of the invention rather than all of them.

The specific embodiments of the present invention will be further described in detail below with reference to the accompanying drawings and embodiments. The following examples are used to illustrate the present invention, but are not intended to limit the scope of the present invention.

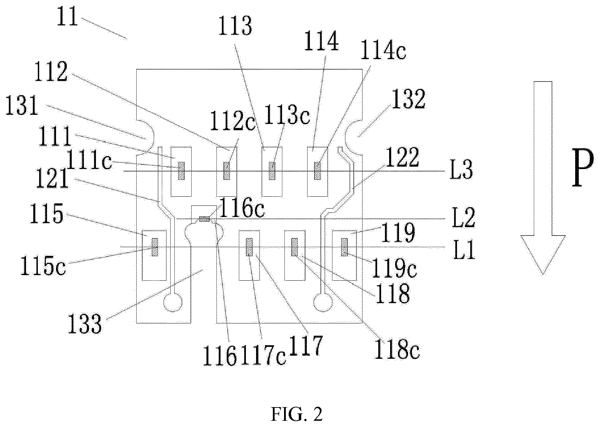

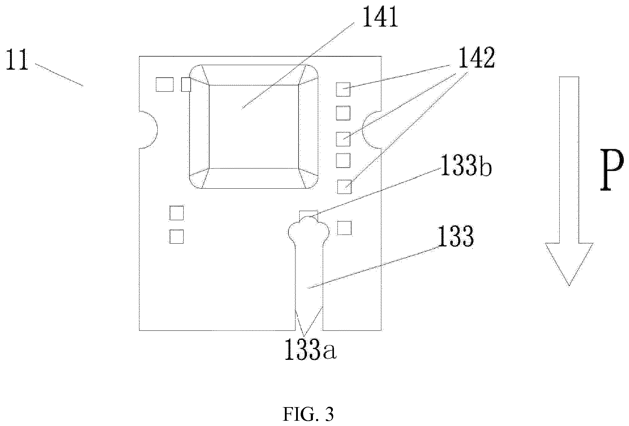

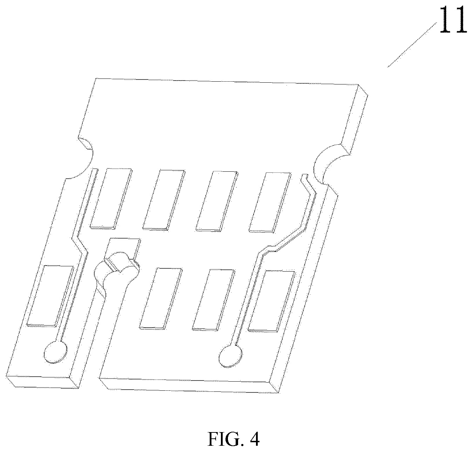

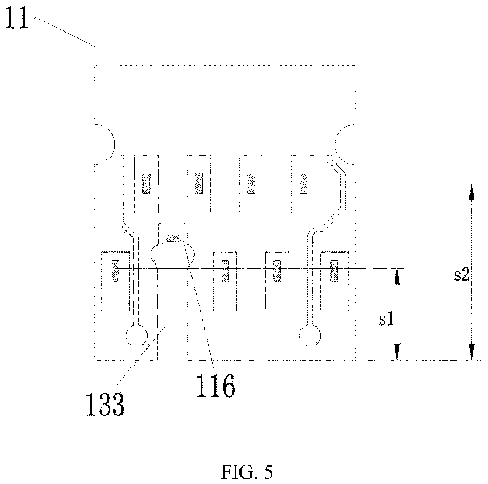

FIG. 2 is a schematic structural diagram of the chip for inkjet printer provided; FIG. 3 is a rear view of the chip for inkjet printer provided by FIG. 2; FIG. 4 is a schematic stereoscopic structural diagram of the chip for inkjet printer provided by FIG. 2; FIG. 5 is a schematic diagram of the principle of the installation process of the chip for inkjet printer provided by FIG. 2. It can be seen with reference to FIGs. 2-5, the present invention provides a chip of inkjet printer, comprising at least a hollow portion 133, a memory 141, two attachment detection terminals, and a power supply terminal 116 connected to the memory 141. Attachment detection contact portions for making an electrical contact with printer-side terminals 32 are formed on the attachment detection terminals. A power supply contact portion 116c for making an electrical contact with the printer-side terminal of the printer 32 is formed on the power supply terminal 116. The power supply contact portion 116c is provided on an end surface of the hollow portion 133 and the attachment detection contact portions are provided on both sides of the hollow portion 133. The distance between the attachment detection contact portion and a front end of the chip 11 is less than the distance between the power supply contact portion 116c and the front end of the chip 11, in an installation direction of installing the chip 11 to the printer; wherein the front end of the chip 11 described in the present technical solutions refers to the front side of the installation direction of the chip 11 in correct installation process of the chip 11.

Firstly, the hollow portion 133 has at least a side end surface 133a and a rear end surface 133b, and the specifically included end surface structure is related to the shape structure of the hollow portion 133, and it can be set by those skilled in the art could make arrangements according to the design requirements. In this embodiment, the side end surface 133a and the rear end surface 133b are collectively referred to as the end surface of the hollow portion 133; and there is no limitation on the end surface of the hollow portion 133 on which the power supply contact portion 116c provided, those skilled in the art could make arrangements according to the design requirements, for example, the power supply contact portion 116c could be provided on the side end surface 133a of the hollow portion 133 or the power supply contact portion 116c is provided on the rear end surface 133b of the hollow portion 133, wherein, preferably, in an installation direction of installing the chip 11 to the printer, the power supply contact portion 116c is provided on the rear end surface 133b of the hollow portion 133, this facilitates the reliable contact between the power supply contact portion 116c and the corresponding printer-side terminal, thereby ensures the stability and reliability of the working of the chip 11.

Secondly, there is no limitation on the specific shape structure of the ship 11, and those skilled in the art could make arrangements according to the design requirements, for example, the chip 11 can be set as a rectangular structure, a cutaway rectangular structure, and a round corner rectangular structure. In addition, there is no limitation on the provided position of the memory 141, for example, the memory 141 may be provided on a side near the rear end of the chip 11, or may also be provided on a side near the side end of the chip 11, and may also be provided in the middle of the chip 11, those skilled in the art could make arrangements according to specific design requirements, and the specific recitation will not be repeated herein; in addition, there is no limitation on the number and the number of lines of connect terminals in at least two lines of connect terminals and those skilled in the art could make arrangements according to specific design requirements, for example, the number of connect terminals can be 5, 7, 9, and the like, and for the set number of lines, it can be two lines, three lines, four lines, and the like, as long as the arrangement of the connect terminals can achieve the desired effect, and the specific recitation will not be repeated herein.

Again, there is no limitation on the specific shape structure of the attachment detection terminal and the power supply terminal 116, and those skilled in the art could make arrangements according to specific design requirements. For example, the attachment detection terminal may be set as a rectangle, a square, or a round corner rectangular structure, and the like. The power supply terminal 116 may be set as a rectangle, a square, or a round corner rectangular structure, and the like, as long as the power supply contact portion and the two attachment detection contact portions are located on different lines, and the specific recitation will not be repeated herein.

It should be noted that, in the present technical solutions, there are at least two cases of relative position between the attachment detection terminal and the power supply terminal 116, including:
In one case, the rear ends of the two attachment detection terminals are provided below the front end of the power supply terminal 116, and the distance between the attachment detection contact portions 115c located in the first line L1, 119c and the front end of the chip 11 is smaller than the distance between the power supply contact portion 116c located in the second line L2 and the front end of the chip 11, its specific structure can refer to Figure 2;

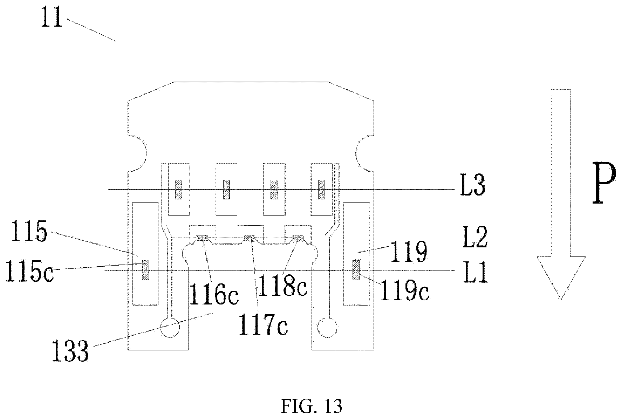

In another case, the rear ends of the two attachment detection terminals are provided above the rear end of the power supply terminal 116, and the front ends of the two attachment detection terminals are provided below the front end of the power supply terminal 116, and the distance between the attachment detection contact portions located in the first line and the front end of the chip 11 is smaller than the distance between the power supply contact portion 116c located in the second line and the front end of the chip 11, that is, the two attachment detection terminals have a portion extending rearward (in the installation direction P), which can extend to a position closer to the rear end of the chip 11, but the positions of contact portions of the two attachment detection terminals will not change; of course, other connect terminals on the chip 11 may also extend in the same direction, which may extend to a position closer to the front end of the chip 11, but the positions of the contact portions of the other connect terminals will not change; and it is also possible to leave a larger design space for the connect terminals in the first line on the front end side in the installation direction P, and it is possible to design the attachment detection terminal wider than other terminals, thereby even if the position of the printer-side terminals 32 is deviation, the detection error will not occur, effectively avoiding the situation in which the attachment is not recognized can be effectively avoided. Its specific structure can be seen in the schematic structural diagram of the chip for inkjet printer shown in FIG. 13. Preferably, the positions of the power supply terminal 116, the attachment detection terminal and the attachment detection contact portion are set as that, in an installation direction of installing the chip 11 to the printer, the distance between the attachment detection contact portion and the front end of the chip 11 is smaller than the distance between the power supply terminal 116 and the front end of the chip 11; and in the installation direction of installing the chip 11 to the printer, the distance between the attachment detection terminal and the front end of the chip 11 is smaller than the distance between the power supply terminal 116 and front end of the chip 11; of course, those skilled in the art could adopt other arrangements, as long as the distance between the attachment detection contact portion in the first line L1 and the front end of the chip 11 is smaller than the distance between the power supply contact portion 116c in the second line L2 and the front end of the chip 11, and the specific recitation will not be repeated herein.

In addition, there is no limitation on the specific shape structures of the attachment detection contact portion and the power supply contact portion 116c, and those skilled in the art could make arrangements according to specific design requirements. For example, the attachment detection contact portion may be set as a rectangle, a square, or a round structure, and the like, and the power supply contact portion 116c may be set as a rectangle, a square, or a round structure, and the like, as long as the distance between the attachment detection contact portion and the front end of the chip 11 is smaller than the distance between the power supply contact portion 116c and the front end of the chip 11, and the specific recitation will not be repeated herein.

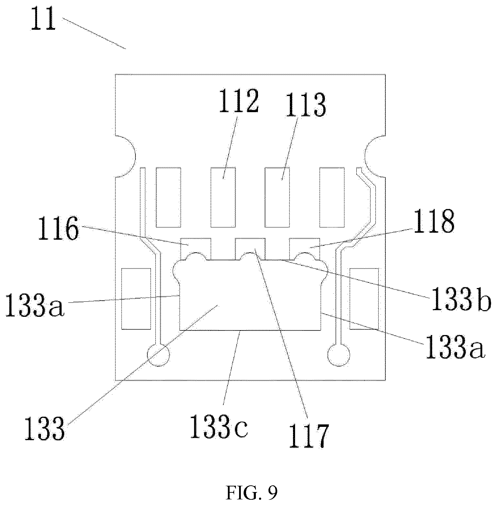

Moreover, there is no limitation on the specific shape structure of the hollow portion 133 in the present technical solution, , and those skilled in the art could make arrangements according to specific design requirements, for example, the hollow portion 133 can be set as a closed structure formed in the interior of the chip 11, and its specific structure can be seen in the schematic structural diagram of the chip 11 as shown in FIG. 9, as that the hollow portion 133 entirely has a Chinese character " 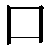 " shape structure, and correspondingly, the hollow portion 133 has side end surfaces 133a, a rear end surface 133b, and a front end surface 133c. Alternatively, the hollow portion 133 is set as an opening structure formed at the lower end of the chip 11, and correspondingly, the hollow portion 133 has side end surfaces 133a and a rear end surface 133b, as shown in the schematic structural diagram of the chip 11 provided in FIG. 2. Of course, those skilled in the art may also adopt other structures of the hollow portion 133, as long as the hollow portion 133 can be provided below the power supply terminal 116 and the power supply contact portion 116c is provided on the rear end surface 133 b of the hollow portion 133, the specific recitation will not be repeated herein.

When the chip 11 is installed on the printer, there is a one-to-one correspondence between the printer-side terminals 32 of the printer and the connect terminals on the chip 11. Specifically, the first contact printer-side terminal 32a corresponds to the first series terminal 111, the second contact printer-side terminal 32b (not shown in the figure) corresponds to the reset terminal 112, the third contact printer-side terminal 32c (not shown in the figure) corresponds to the clock terminal 113, the fourth contact printer-side terminal 32d (not shown in the figure) corresponds to the second series terminal 114, the fifth contact printer-side terminal 32e (not shown in the figure) corresponds to the first attachment detection terminal 115, the sixth contact printer-side terminal 32f corresponds to the power supply terminal 116, the seventh contact printer-side terminal 32g (not shown in the figure) corresponds to the ground terminal 117, the eighth contact printer-side terminal 32h (not shown in the figure) corresponds to the data terminal 118, and the ninth contact printer-side terminal 32i (not shown in the figure) corresponds to the second attachment detection terminal 119, for example. Of course, the specific number and position of the contact printer-side terminals 32 can be set by those skilled in the art according to the specific design requirements, as long as the printer-side terminals 32 on the printer and the connect terminals on the chip 11 are in one-to-one correspondence.

In addition, the rubbing distances on the chip 11 include a rubbing distance between the printer-side terminals 32 for contacting with the attachment detection contact portion and the chip 11 and a rubbing distance between the printer-side terminals 32 contacting with the power supply terminal 116 and the chip 11, wherein the hollow portion 133 is provided so that the rubbing distance between the printer-side terminals 32 contacting with the power supply terminal 116 and the chip 11 is almost 0, but the distance between the power supply terminal 260 and the front end of the board 200 in the prior art is far greater than the rubbing distance in the technical solution. Specifically, the power supply terminal 260 in the prior art is provided on the first row of the board 200, and the distance between the first row and the front end of the board 200 is 11, therefore, the rubbing distance between the power supply terminal 260 and the front end of the board 200 is also t1, t1 is far greater than the rubbing distance which is 0 between the power supply terminal 116 and the front end of the board 200 in the present technical solution; therefore, by disposing the hollow portion 133, the contact stroke between the printer-side terminals 32 contacting with the power supply terminal 116 and the chip 11 is effectively reduced, the wear of the printer-side terminals 32 is reduced, thereby avoiding the contact failure and the problem of the electrical transmission between the chip 11 and the printer caused by the wear of the printer-side terminals 32, which improves the stability and reliability of the use of the chip 11.

In addition, the chip 11 provided by the present embodiment, through providing the distance between the attachment detection contact portion in the first line and the front end of the chip 11 is less than the distance between the power supply contact portion 116c in the second line and the front end of the chip, i.e. so that the power supply contact portion 116c is located at the upper end of the two attachment detection contact portions, effectively avoids the existing situation in the prior art that the power supply terminal 116 on the chip 11 have been contacted with the corresponding printer-side terminals 32 on the printer, but attachment detection terminal cannot establish a normal connection, resulting in the printer cannot identify the chip 11 or damage of the chip 11, the printer, ensuring the stability and reliability of use of the chip, and beneficial to the promotion and application of the market.

On the basis of the above embodiments, with reference to FIGs.2-5, the further including: a ground terminal 117 and a data terminal 118 connected with the memory 141. A ground contact portion 117c for making electrical contact with the printer-side terminal of the printer 32 is formed on the ground terminal 117. A data contact portion 118c for making electrical contact with the printer-side terminal of the printer 32 is formed on the data terminal 118, and a hollow portion 133 is formed below at least one of the ground terminal 117 and the data terminal 118, and the hollow portion 133 is connected with a hollow portion 133 located below the power supply terminal 116, and at least one of the ground contact portion 117c and the data contact portion 118c is provided on the rear end surface 133b of the hollow portion 133.

Wherein, there is no limitation on the specific shape structures of the ground terminal 117 and the data terminal 118, and those skilled in the art could make arrangements according to specific design requirements. For example, the ground terminal 117 may be set as a rectangle, a square, or a round corner rectangular structure, and the like. The data terminal 118 may be set as a rectangle, a square, or a round corner rectangular structure, and the like. There is no limitation on the specific shape structures of the ground contact portion 117c located on the ground terminal 117 and the data contact portion 118c located on the data terminal 118, and those skilled in the art could make arrangements according to specific design requirements. For example, the above contact portions may be set as a rectangle, a round, or an oval structure, and the like, as long as at least one of the ground contact portion 117c and the data contact portion 118c is provided on the rear end surface 133b of the hollow portion 133.

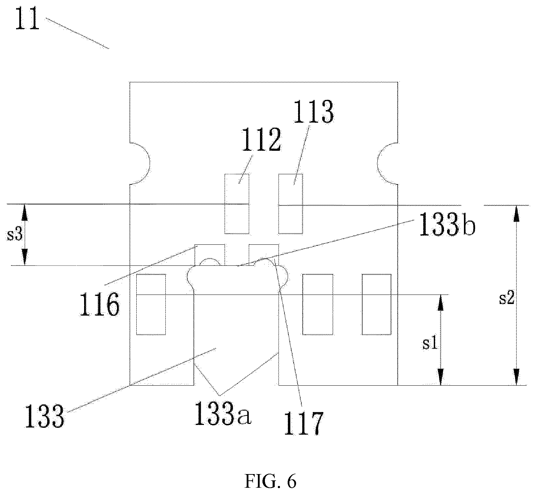

Specifically, the structure described in the above technical solution includes three usage cases, including:
In the first case, the ground terminal 117 is provided on the rear end surface 133b of the hollow portion 133, but the data terminal 118 is not connected with the hollow portion 133, its specific structure can be seen in the schematic structural diagram of the chip for inkjet printer shown in FIG. 6, i.e., the ground terminal 117 and the power supply terminal 116 are arranged in parallel on the rear end surface 133b of the hollow portion 133, and the ground contact portion 117c and the power supply contact portion 116c are both provided on the rear end surface 133b of the hollow portion 133, and there is no limitation on the specific position of the data terminal 118, and the data terminal 118 may be provided parallel to the attachment detection terminal in the first line L1; of course, it may also be provided in other positions, those skilled in the art could make arrangements the specific setting positions according to specific design requirements, and the specific recitation will not be repeated herein;

In the second case, the data terminal 118 is provided on the rear end surface 133b of the hollow portion 133; that is, the data terminal 118 and the power supply terminal 116 are arranged in parallel on the rear end surface 133b of the hollow portion 133, and the data contact portion 118c and the power supply contact portion 116c are both provided on the rear end surface 133b of the hollow portion 133, and there is no limitation on the specific location of the ground terminal 117, and the ground terminal 117 may be provided parallel to the attachment detection terminal in the first line L1; of course, it may also be provided in other positions, those skilled in the art could set the specific setting positions according to specific design requirements, and the specific recitation will not be repeated herein;

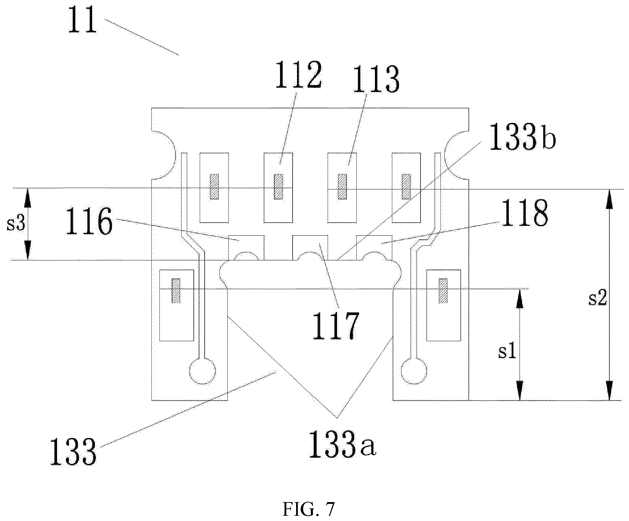

In the third case, the ground terminal 117 and the data terminal 118 are provided on the rear end surface 133b of the hollow portion 133. At this time, the area, where the power supply contact portion 116c, the ground contact portion 117c, and the data contact portion 118c are located, is located at the rear end of the area where the two attachment detection contact portions are located, and in the installation direction of installing the chip 11 to the printer, the area, where the power supply terminal 116, the ground terminal 117, and the data terminal 118 are located, is located at the rear end of the area where the two attachment detection terminals are located, its specific structure can be seen in the schematic structural diagram of the chip for inkjet printer shown in FIGS. 7-8, that is, the power supply terminal 116, the grounding terminal 117, and the data terminal 118 are all arranged in parallel on the rear end surface 133b of the hollow portion 133, and can constitute a first area Q1 with the area where the other connect terminals locating on the rear end of the power supply terminal 116 are located, and constitute a second area Q2 with the area where the two attachment detection terminals are located, and the first area Q1 and the second area Q2 do not intersect, and the power supply contact portion 116c, the ground contact portion 117c and the data contact portion 118c are all provided on the rear end surface 133b of the hollow portion 133 so that the 32 can be easily contacted.

By providing at least one of the data terminal 118 and the ground terminal 117 on the rear end surface 113b of the hollow portion 133, the area of the hollow portion 133 is effectively increased, thereby the contact stroke between the printer-side terminals 32 and the chip 11 is more effectively reduced, the wear of the printer-side terminals 32 is reduced, and the contact failure and the problem of the electrical transmission between the chip 11 and the printer caused by the wear of the printer-side terminal are avoided, which further improves the stability and reliability of the use of the chip 11, effectively extends the usage life of the printer-side terminals 32 and the chip 11, and is beneficial to the promotion and application of the market.

On the basis of the above embodiments, with reference to FIGs. 2-5, it can further be seen that at least one control terminal connected with the memory 141 is also included, and a control contact portion for making electrical contact with the printer-side terminal of the printer 32 is formed each control terminal. The distance between each control contact portion and the front end of the chip 11 is greater than the distance between the power supply contact portion 116c and the front end of the chip 11.

Wherein, there is no limitation on the specific number of the at least one control terminal and the specific terminal type included, and those skilled in the art could make arrangements according to specific design requirements, for example, the number of at least one control terminal can be set to one, and also can be set to two, and the two control terminals may be specifically a reset terminal and a clock terminal. Alternatively, the number of at least one control terminal is set to three, and the three control terminals may be specifically a reset terminal, a clock terminal and a series-connected terminal. Alternatively, the number of at least one control terminal may be set to four and the specific four control terminals may include a reset terminal, a clock terminal, a first series-connected terminal, and a second series-connected terminal. Of course, those skilled in the art could adopt other configurations, as long as the distance between each control contact portion and the front end of the chip 11 is greater than the distance between the power supply contact portion 116c and the front end of the chip 11, and the specific recitation will not be repeated herein.

For the above embodiments, in order to more clearly understand the present technical solution, the specific design cases are illustrated as follows.

Case 1: Referring to FIG. 6, it can be seen that the at least one control terminal in the present technical solution is set to include the reset terminal 112 and the clock terminal 113, and the contact portion 112c and the clock contact portion 113c for making electrical contact with the printer-side terminal of the printer 32 are provided on the reset terminal 112 and the clock terminal 113 respectively; the distances between the reset contact portion 112c and the front end of the chip 11 and between the clock contact portion 113c and the front end of the chip 11 are greater than the distance between the power supply contact portion 116c and the front end of the chip 11.

Wherein, there is no limitation on the specific shape structures of the reset terminal 112 and the clock terminal 113, and those skilled in the art could make arrangements according to specific design requirements. For example, the reset terminal 112 may be set as a rectangle, a square, a round corner rectangular, or a cutaway rectangular structure, and the like, the clock terminal 113 may be set as a rectangle, a square, a round corner rectangular, or a cutaway rectangular structure, and the like. There is no limitation on the specific shape structures of the reset contact portion 112c and the clock contact portion 113c, and those skilled in the art could make arrangements according to specific design requirements. For example, the reset contact portion 112c is also set as a rectangle, a square, a round, or a oval structure, and the like, and the clock contact portion 113c is also set as a rectangle, a square, a round, or a oval structure, and the like, those skilled in the art could set the specific shape structures according to specific design requirements, as long as the distances between the reset contact portion 112c and the front end of the chip 11 and between the clock contact portion 113c and the front end of the chip 11 are greater than the distance between the power supply contact portion 116c and the front end of the chip 11, and the specific recitation will not be repeated herein.

Through providing clock terminal 113 and reset terminal 112, the working state of the chip 11 can be effectively controlled and adjusted, and the distance between the reset contact portion 112c and the front end of the chip 11 and between the clock contact portion 113c and the front end of the chip 11 are greater than the distance between the power supply contact portion 116c and front end of the chip 11, so that the connect terminals provided on the chip 11 evenly distributed, which makes the printer-side terminals 32 contact with each connect terminal on the chip 11 stably and reliably, thereby ensuring the practicality of the chip 11 .

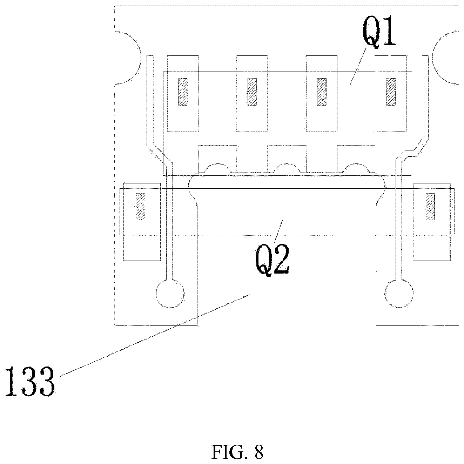

Case 2: FIG. 7 is a schematic structural diagram one of a chip of inkjet printer provided; FIG. 8 is a schematic structural diagram two of a chip of inkjet printer provided; and on the basis of the above embodiments, referring to FIGs. 7-8, it can be seen that the at least one control terminal in the present technical solution is set to include a reset terminal 112, a clock terminal 113, and a first series-connected terminal 111 and a second series-connected terminal 114 arranged in parallel with the reset terminal 112 and the clock terminal 113. A first series-connected contact portion 111c and a second series-connected contact portion 114c for making electrical contact with the printer-side terminal of the printer 32 are provided on the series-connected terminal 111 and the second series-connected terminal 114 respectively. The distances between the first series-connected contact portion 111c and the front end of the chip 11, between the second series-connected contact portion 114c and the front end of the chip 11, between the reset contact portion 112c and the front end of the chip 11, as well as between the clock contact portion 113c and the front end of the chip 11 are the same.

In the specific process of attachment, the power supply terminal 116, the ground terminal 117, and the data terminal 118 in the installation direction P are located on the rear end surface of the hollow portion 133; so that in the installation direction P, the reset terminal 112, the clock terminal 113, and the first series-connected terminal 111 and the second series-connected terminal 114 (or the reset contact portion 112c, the clock contact portion 113c, the first series-connected contact portion 111c, and the second series-connected contact portion 114c) are all located at the rear ends of the power supply terminal 116, the ground terminal 117, and the data terminal 118 (or the power supply contact portion 116c, the ground contact portion 117c, and the data contact portion 118c), and result in that in the installation direction P, the reset terminal 112, the clock terminal 113, the first series-connected terminal 111, and the second series terminal 114, the power supply terminal116, the ground terminal 117 and the data terminal 118 are called the first terminal, and the first attachment detection terminal 115 and the second attachment detection terminal 119 are called the second terminal. Since during the specific working process, the voltage of the first terminal is low, the voltage of the second terminal is high, the short circuit may occur between the first terminal and the second terminal. In order to avoid the generation of the short circuit, the contact portion area Q1 of the first terminal is set to be non-overlapping area with the second contact portion area Q2 of the second terminal, so that the generation of the short circuit between the first terminal and the second terminal can be further avoided, and it can make sure that, the first terminal is in contact with the printer-side terminals 32 after the detection of the second terminal is completed. Moreover, by disposing the hollow portion 133, the contact stroke between the printer-side terminals 32 for contacting with the power supply terminal 116 and the chip 11 is effectively reduced, the wear of the printer-side terminals 32 is reduced, and the contact failure and the problem of the electrical transmission between the chip 11 and the printer caused by the wear of the printer-side terminal are avoided, which improves the stability and reliability of the use of the chip 11.

Wherein, there is no limitation on the specific shape structure of the first series-connected terminal 111 and the second series-connected terminal 114, and those skilled in the art could make arrangements according to specific design requirements, for example, the first series-connected terminal 111 and the second series-connected terminal 114 can be set as a rectangle, a square, a cutaway rectangular, or a round corner rectangular structure, and the like. There is no limitation on the specific shape structure of the first series-connected contact portion 111c and the second series-connected contact portion 114c, and those skilled in the art could make arrangements according to specific design requirements. For example, the first series-connected contact portion 111c and the second series-connected contact portion 114c are set as a rectangle, a square, a round, or a oval structure, and the like, as long as the distances between the first series-connected contact portion 111c and the front end of the chip 11, between the second series-connected contact portion 114c and the front end of the chip 11 and the distances between the reset contact portion 112c and the front end of the chip 11, between the clock contact portion 113c and the front end of the chip 11 are the same, and the specific recitation will not be repeated herein. In addition, there is no limitation on the specific position of the at least one control terminal and other terminals provided on the chip 11, in order to ensure that the printer-side terminals 32 are in one-to-one contact with the connection terminals, and no influence is generated between the printer-side terminals 32, it is preferable that the each terminal on the chip 11 is provided in at least three lines of contact terminal arranged from the front end to the rear end of the chip 11, and the each terminal in the at least three lines of connect terminals is staggered in a direction that perpendicular to the installation direction of installing the chip 11 to the printer. Moreover, in the at least three lines, the front two lines from the front end side to the rear end side in the installation direction of installing the chip 11 to the printer are the first line and the second line in order, and the attachment detection contact portion is located in the first line, and the power supply contact portion 116c is located in the second line, so that it is also a staggered structure between the printer-side terminals 32 connecting with the connect terminals respectively, which effectively ensures the stability and reliability of the connection between the printer-side terminals 32 and the connect terminals, and avoids the mutual interference between the respective printer-side terminals 32.

On the basis of the above embodiments, continuously with reference to FIGs. 2-8, it can be seen that, in order to confirm the stability and reliability of the each connect terminal on the chip 11, a first short circuit detection terminal 121 and a second short circuit detection terminal 122 is provided between the two attachment detection terminals on the chip 11. Both of the power supply terminal 116 and the at least one control terminal are provided between the first short circuit detection terminal 121 and the second short circuit detection terminal 122.

Wherein, the first short circuit detection terminal 121 and the second short circuit detection terminal 122 are detection terminals used for detecting whether a short circuit is occurred between the connect terminals on the chip 11. There is no limitation on the specific shape structure of the first short circuit detection terminal 121 and the second short circuit detection terminal 122, and those skilled in the art could make arrangements according to specific design requirements, for example, the first short circuit detection terminal 121 and the second short circuit detection terminal 122 can be set as a rectangular, a bar, a cylindrical, a round corner rectangular structure or other structures and the like. In addition, there is no limitation on the specific positions of the first short circuit detection terminal 121 and the second short circuit detection terminal 122, and those skilled in the art could make arrangements according to specific design requirements, for example, the first short circuit detection terminal 121 and the second short circuit detection terminal 122 are symmetrically provided on the left and right sides of the chip 11, or provided on the rear or front end of the chip 11, as long as the foregoing functions can be achieved, and the specific recitation will not be repeated herein.

Through the provided first short circuit detection terminal 121 and second short circuit detection terminal 122, the connection state between the connect terminals on the chip 11 can be detected effectively in real time, and when a short circuit between the connect terminals is occurred, the early warning can be performed in a timely and effective manner so as to avoid causing greater damage to the chip 11 or the printer and improve the security and reliability of the use of the chip 11.

On the basis of the above embodiments, continuously with reference to FIGs. 1-9, it can be seen that, in order to make the chip 11 fixed on the ink cartridge, a first positioning portion 131 and a second positioning portion 132 that are recessed toward the inside of the chip 11 are provided on the chip 11. The first positioning portion 131 and the second positioning portion 132 are located above the reset contact portion 112c and the clock contact portion 113c. The first positioning portion 131 and the second positioning portion 132 are collectively referred to as a positioning portion.

Wherein, there is no limitation on the shape of the positioning portions, and those skilled in the art can also set according to specific design requirements, for example, the positioning portions are set to as a semi-circular, triangular or rectangular structure and the like, as long as the chip 11can be conveniently fixed and installed; and there is no limitation on the specific position of the positioning portions, as long as the positioning portions are provided on the reset contact portion 112c and the clock contact portion 113c, and the specific recitation will not be repeated herein; through the provided positioning portion, the instillation efficiency of the chip 11 is effectively improved and the convenience and reliability of the use of the chip 11 are improved.

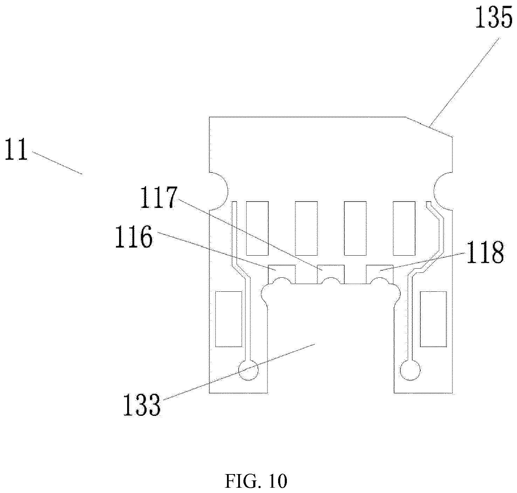

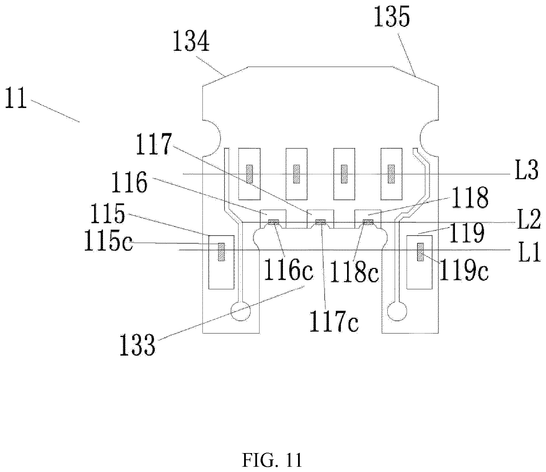

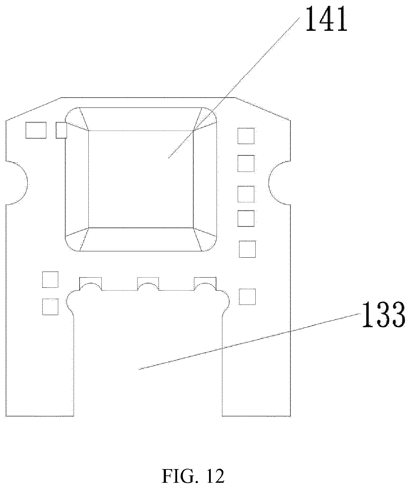

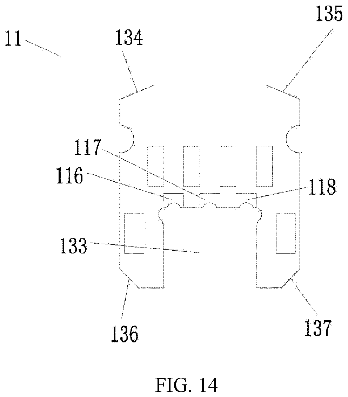

In addition, there is no limitation on the specific shape structure of the chip 11 in the present technical solution, and those skilled in the art could make arrangements according to specific design requirements, for example, it can be set as chip 11 having the rectangular structure shown in FIG. 2 , and of course, it can also be set to other shapes of the chip 11 structure, such as a cut-angle rectangular structure, wherein the cut-angle rectangular structure includes a variety of usage cases, including:
the structure of the chip 11 having one chamfer corner, the specific structure of which can be seen in the schematic structural diagram of the chip for inkjet printer provided in FIG. 10. Referring to FIG. 10, it can be seen that the structure of the chip 11 provided in the drawing has a second chamfer corner 135 which is provided at the upper right end corner of the chip 11, of course, those skilled in the art can also set the second chamfer corner 135 to the upper left end corner, the lower left end corner or the lower right end corner of the chip 11, and the like. Those skilled in the art could set the specific attachment position according to specific design requirement, as long as the chip 11 has one chamfer angle;
the structure of the chip 11 having two chamfer corners, the specific structure of which can be seen in the schematic structural diagram of the chip for inkjet printer provided in FIG. 11; FIG.12 is a rear view of the chip for inkjet printer provided in FIG. 11; Referring to FIGs. 1 1-12, it can be seen that the chip 11 is provided with two chamfer corners, the two chamfer corners are respectively provided at the upper left end corner and the upper right end corner of the chip 11, i.e., the first chamfer corner 134 and the second chamfer corner 135. Of course, those skilled in the art can also set the two chamfer corners at other positions, for example, one of the chamfer corners is provided at the upper left end corner or the upper right end corner, the other chamfer corner is provided at the lower left end corner or the lower right end corner, etc. Specifically, those skilled in the art can make any arrangements according to specific design requirements, as long as the chip 11 is configured to have two chamfer corners, and the specific recitation will not be repeated herein;
the structure of the chip 11 having three chamfer corners, i.e. , the chip 11 is provided with a first chamfer corner 134, a second chamfer corner 135, and a third chamfer corner 136, and there is no limitation on the specific positions of the first chamfer corner 134, the second chamfer corner 135 and the third chamfer corner 136, those skilled in the art could make arrangements according to specific design requirements, for example, any one of the four end corners of the chip 11 is not set with a chamfer corner, and the other three end corners are set with chamfer corners, as long as the chip 11 has three chamfer corners, and the specific recitation will not be repeated herein;
the structure of the chip 11 having four chamfer corners, the specific structure of which can be seen in the schematic structural diagram of the chip for inkjet printer provided in FIG. 14. Referring to FIG. 14, it can be seen that the four end corners of the chip 11 are all provided with chamfer corners, i.e., are the first chamfer corner 134, the second chamfer corner 135, the third chamfer corner 136 and the fourth chamfer corner 137 respectively.

Through the provided chamfer corners, the volume of the chip 11 can be reduced, the ink cartridge 20 and the chip 11 can be quickly and effectively installed, the attachment efficiency of the ink cartridge 20 and the chip 11 can be improved, and at the same time, the ink cartridge installation portion 30 is worn by the chip 11 can be avoided during the installation process. Of course, those skilled in the art can also set other shape structures of the chip 11, for example, the chamfer corners on the chip 11 are set to as round corners and the like, as long as the volume of the chip 11 can be reduced, and the attachment is convenient, and the specific recitation will not be repeated herein.

Another aspect of the present invention provides an inkjet printer, comprising the above chip of inkjet printer.

The inkjet printer provided by the invention effectively avoids the existing situation in the prior art that the power supply terminal 116 on the chip 11 has been contacted with the corresponding printer-side terminals 32 on the printer, but attachment detection terminal cannot establish a normal connection, resulting in the printer cannot identify the chip 11 or the damage condition of the chip 11, the printer, ensuring the stability and reliability of use of the chip, through the provided printer-side terminals 32 corresponding to the structure of the chip for inkjet printer. In addition, by disposing the hollow portion 133, the contact stroke between the printer-side terminal and the chip 11 is effectively reduced, the wear of the printer-side terminals 32 is reduced, and the contact failure and the problem of the electrical transmission between the chip 11 and the printer caused by the wear of the printer-side terminals 32 are avoided, which improves the stability and reliability of the use of the chip 11, and is beneficial to the promotion and application of the market.

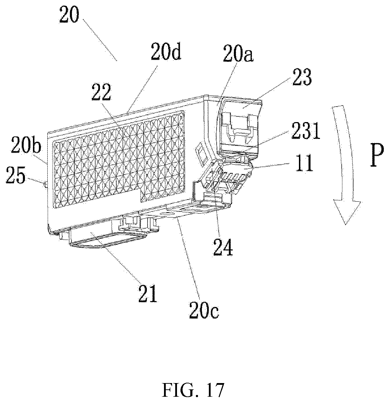

In the specific process of attachment, firstly, the chip 11 needs to be installed on the ink cartridge 20, wherein the specific structure of the ink cartridge 20 can refer to FIG. 17 which is a schematic stereoscopic structural diagram of the ink cartridge 20; referring to FIG. 17, it can be seen that the ink cartridge 20 specifically includes a housing 22. A first face 20a, a second face 20b, a third face 20c and a fourth face 20d are provided around the housing 22. The housing 22 is provided with an ink outlet 21, and the ink outlet 21 is provided on the third face 20c of the housing 22, the chip 11 is installed on the ink cartridge 20 through the chip holder 24.

Of course, the specific structure of the ink cartridge 20 is not limited to the above structure, and those skilled in the art could make arrangements according to specific design requirements, as long as the chip 11 can be installed on the ink cartridge 20, and the specific recitation will not be repeated herein.

Next, the ink cartridge 20 having the chip 11 is installed on the inkjet printer. Specifically, the ink cartridge 20 is provided with a chip holder 24 for installing the chip 11, and the chip holder can be used to install the chip 11 on the ink cartridge 20; then the ink cartridge 20 having the chip 11 is installed on the inkjet printer, in order to improve the convenience and reliability of the attachment of the ink cartridge 20 and the inkjet printer, a first stuck position 231 is provided on the handle 23, and a second stuck position 25 for engaging with the inkjet printer is provided on the fourth face 20d of the ink cartridge 20, and a handle 23 for separately assembling and disassembling the ink cartridge 20 is also provided on the ink cartridge 20, and the first stuck position 231 is provided on the lower end of the handle 23, therefore, the ink cartridge 20 with the chip 11 can be effectively installed on the inkjet printer through the first stuck position 231 and the second stuck position 25, thereby effectively ensuring the reliability of the attachment of the ink cartridge 20 and the inkjet printer.

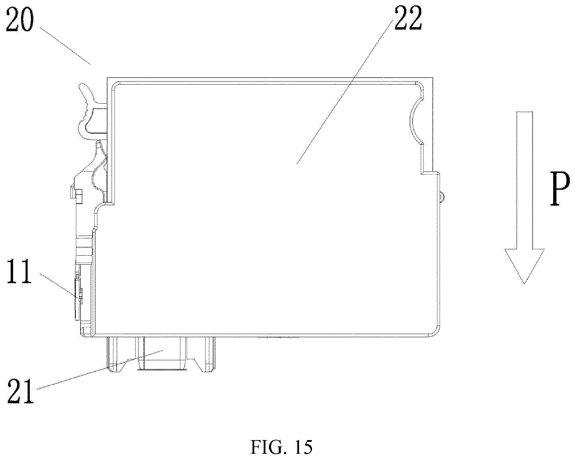

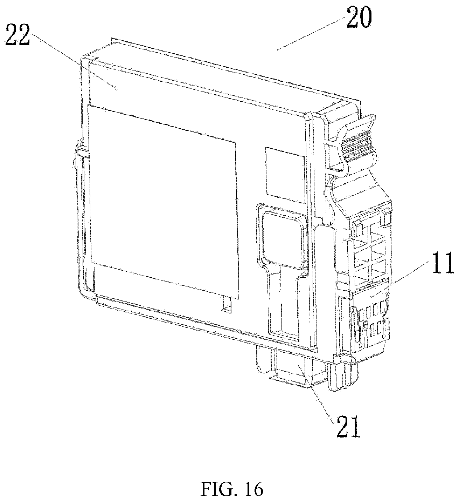

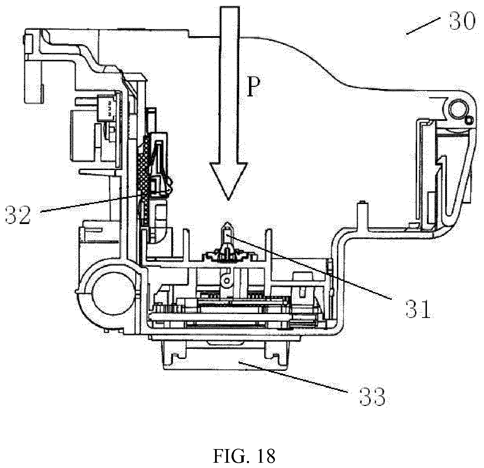

Of course, the chip in present technical solution can also be installed on the ink cartridge 20 with different structures. For example, FIG.15 is a schematic structural diagram one of the provided ink cartridge 20; FIG.16 is a schematic structural diagram two of the provided ink cartridge 20; FIG.18 is a schematic structural diagram of the provided ink cartridge installation portion 30. Referring to FIGs. 15-16 and 18, it can be seen that the ink cartridge 20 entirely has a rectangular-like structure. The ink cartridge 20 includes a housing 22, the ink outlet 21 is provided on the bottom end of the housing 22, and the chip 11 is installed on one side of the housing 22, and the ink cartridge 20 is installed on the printer through the ink cartridge installation portion 30. Specifically, the ink cartridge 20 is installed on the inkjet printer through the ink cartridge installation portion 30. In terms of the ink cartridge installation portion 30, the ink cartridge installation portion 30 is provided with an ink supply needle 31, a printer-side terminal 32 and a print head 33, when the ink cartridge 20 is installed to the ink cartridge installation portion 30, since the ink supply needle 31 is needle-shaped, the ink supply needle 31 can pierce the ink outlet 21 to be connected to the ink inside the housing 22, wherein the direction P indicates the direction in which the ink cartridge 20 is installed to the attachment portion, which then can provide a function of supplying ink to the printer. The printer-side terminals 32 contacts the connect terminals on the chip 11 to implement the attachment detection function of the ink cartridge 20 and the data transmission function between the printer and the ink cartridge 20. Generally, the chip 11 stores information, such as manufacturer information, ink amount information, ink cartridge type information, ink color information, and the like.

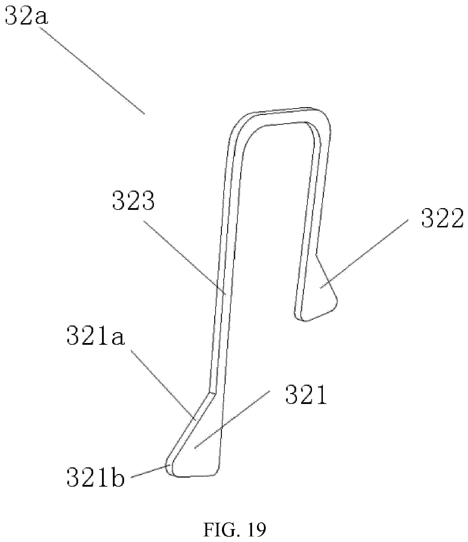

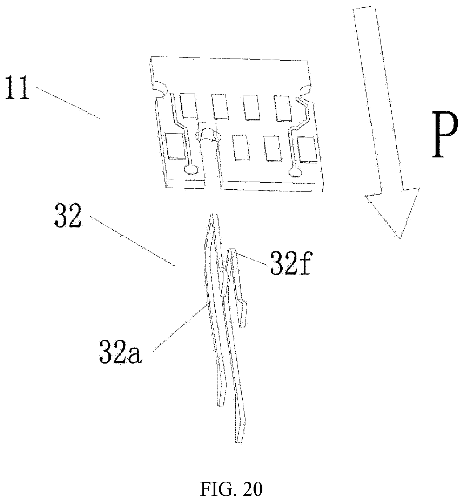

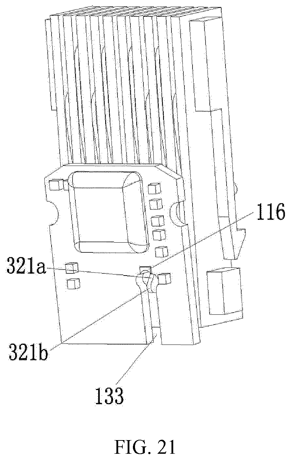

Wherein, there is no limitation on the specific shape structure of the printer-side terminals 32 in the above installation process, and those skilled in the art could make arrangements according to specific design requirements. It can be understood that the number and relative position of the printer-side terminals 32 correspond to the number and the relative position of connect terminals on the chip 11, so as to facilitate the contact of the connect terminals on the chip 11 in one-to-one correspondence. Wherein, the schematic structural diagram of the first printer-side terminal 32a provided by FIG. 19 is more preferable. FIG. 20 is a schematic structural diagram of a separate connection structure of the chip for inkjet printer and the printer-side terminal provided; FIG. 21 is a schematic structural diagram of a connection structure of the provided chip for inkjet printer and the printer-side terminal. Referring to FIGs.19-21, it can be seen that the structure of the remaining printer-side terminals 32b-32i connected with the connect terminals on the chip 11 is the same as that of the printer-side terminal 32a. Specifically, the printer-side terminals 32 include a first contact head 321 and a second contact head 322. The first contact head 321 is connected to the second contact head 322 through a connect portion 323, and the first contact head 321 and the second contact head 322 are all have a triangular convex structure. The triangular convex structure includes a ridge-shaped peak portion 321b and a slope portion 321a provided between the peak portion 321b and the connect portion 323.

When the printer-side terminals 32 contact with the connect terminals on the chip 11, in terms of the other connect terminals except the connect terminals located at the upper end of the hollow portion 133, the peak portions 321b of the printer-side terminals 32 are in contact with the connect terminals, but in terms of the connect terminals at the upper end of the hollow portion 133, the slope portions 321a of the printer-side terminals 32 are in contact with the connect terminals through the hollow portion 133; for example, when the upper end of the hollow portion 133 is only provided on the power supply terminal 116, the slope portion 321a on the printer-side terminal 32 re in contact with the contact portion of the power supply terminal 116 through the hollow portion 133, the specific connection structure of which can refer to FIG.21. Therefore, during the chip 11 installation process, the ridge-shaped peak portions 321b of the printer-side terminals 32 do not rub against the chip 11, so the peak portion 321b of the printer-side terminal 32 (power supply printer-side terminal 32) will not be worn after the printer is used for a period of time, and only the wear of the slope portion 321a will occur, because the slope portion 321a is a sloped surface, rather than a peak portion, the wear of the slope portion 321a is slight compared with the rubbing between the peak portion 321b and the chip 11, and at the same time, the setting of the hollow portion 133 shortens the contact stroke between the printer-side terminals 32 and the chip 11, reduces the wear of the printer-side terminal, avoids the problem of the contact failure and the problem of the electrical transmission between the chip 11 and the printer caused by the wear of the printer-side terminals 32; thereby the entire installation processes of the chip 11 and the printer are completed, and the printer can be started for printing at any time when printing is required.

In the specific applications, as shown in FIGs.2-5, it can be seen that the chip 11 has a hollow portion 133, so that the overall shape of the chip 11 is approximate to "n" shape; the chip 11 includes nine connect terminals, a first short circuit detection terminal 121, a second short circuit detection terminal 122, a first positioning portion 131, a second positioning portion 132, a hollow portion 133, a memory 141, an electrical element 142 for implementing other electrical functions, a first surface and a second surface, wherein the direction P indicates the direction in which the chip 11 is installed with the ink cartridge 20 to the attachment portion; the chip 11 is in contact with the printer-side terminals 32 in the printer, and those skilled in the art could understand that the printer-side terminals 32 have nine printer-side terminals 32a-32i that are mutually independently connected with nine connect terminals respectively. The contact positions of the nine connect terminals in contact with the printer-side terminals 32 are the connect terminal contact portions, wherein the nine connect terminals include a first series-connected terminal 111, a second series-connected terminal 114, a reset terminal 112, a clock terminal 113, a first attachment detection terminal 115, a second attachment detection terminal 119, a power supply terminal 116, a ground terminal 117 and a data terminal 118, and a first short circuit detection terminal 121 and a second short circuit detection terminal 122 are also provided on the chip 11. The functions of the respective terminals are: the first attachment detection terminal 115 and the second attachment detection terminal 119 are used to detect whether the ink cartridge 20 is installed correctly; the reset terminal 112, the clock terminal 113, the power supply terminal 116, the ground terminal 117and the data terminal 118 are connected to the memory 141 so as to be able to communicate with the memory 141. In the prior art, the voltage supplied from the printer to the first attachment detection terminal 115 and the second attachment detection terminal 119 is generally 42V, and the voltage of the operation voltage of the memory 141 and its power supply terminal 116 and the data terminal 118 is 3.3V, in this case, a short circuit between the terminals may occur. The chip 11 or the printer will be damaged, if the short circuit occurs, therefore, the present embodiment sets the first short circuit detection terminal 121 and the second short circuit detection terminal 122 that can detect the short circuit between the terminals. The power supply terminal 116 is used to take and supply the power form the printer to the memory 141 on the chip 11, so that the power could be supplied to the data transmission between the chip 11 and the printer, and the data transmission between the chip 11 and the printer is ensured. The power supply terminal 116 is in the most important role, and for the stability of the contact, the power supply terminal 116 needs to be placed near the ink outlet 21. However, if a short circuit occurs between the power supply terminal 116 and the first attachment detection terminal 115 and between the power supply terminal 116 and the second attachment detection terminal 119, it will result in that the power supply voltage to the memory 141 is too high, and the memory 141 will be burned out. Therefore, the power supply terminal 116 (power supply contact portion 116c) needs to be located as far as possible from the first attachment detection terminal 115 and the second attachment detection terminal 119 (the first attachment detection contact portion 115c and the second attachment detection contact portion 119c). As shown in FIGs.2-5, in the installation direction P, it can be seen that the first attachment detection contact portion 115c and the second attachment detection contact portion 119c are provided on the front end side of the power supply terminal 116 and the power supply contact portion 116c, and the power supply terminal 116 is provided on the upper rear end surface of the hollow portion 133. The first attachment detection contact portion 115c and the second attachment detection contact portion 119c are located at both left and right sides of the hollow portion 133 in a direction perpendicular to the installation direction P. As shown in Fig.2, each of the terminal contact portions is arranged in multiple lines in the installation direction P, the chip in the present embodiment includes three lines of connect terminals, which in order are L1, L2, and L3 from the front end side of the installation direction P. L1 line connect terminals include the first attachment detection terminal 115, the ground terminal 117, the data terminal 118 and the second attachment detection terminal 119, L2 line connect terminal includes the power supply terminal 116, L3 line connect terminals include the first series-connected terminal 111, the reset terminal 112, the clock terminal 113 and the second series-connected terminal 114. The connect terminals may also be arranged in an arrangement as shown in Fig. 11. Specifically, L1 line connect terminals include the first attachment detection terminal 115 and the second attachment detection terminal 119, L2 line connect terminals include the power supply terminal 116, the ground terminal 117 and the data terminal 118, and the L3 line connect terminals include the first series-connected terminal 111, the reset terminal 112, the clock terminal 113 and the second series-connected terminal 114. Of course, those skilled in the art can also adopt other arrangement forms, as long as the contact portion of the power supply terminal 116 can be located in the second line L2, and the three lines of contact portions do not overlap in the direction perpendicular to the installation direction P, that is, a staggered structure is provided between the respective connect terminals on the three lines.

Through the above design of the using structure, the power supply terminal 116 (power supply contact portion 116c) is far away from the first attachment detection terminal 115 and the second attachment detection terminal 119 (the first attachment detection contact portion 115c and the second attachment detection contact portion 119c), which effectively reduces the occurrence possibility of a short circuit. At the same time, it may avoid that the power supply terminal 116 will not be in contact with the printer-side terminal 32 in a case of the first attachment detection terminal 115 and the second attachment detection terminal 119 are not in contact the power supply terminal 116, even if when the position of the printer-side terminals 32 is misaligned after the printer has been used for a long period of time, which prevents the situations that the chip 11 could not be recognized or the chip 11 is damaged due to the connection between the power supply terminal 116 and the printer-side terminal 32 before the attachment detection is not completed.

When three lines of connect terminals are provided on the used chip 11, the specific structure of which is as shown in Fig.6, the rubbing distance of the printer-side terminals 32 contacting the three lines of connect terminals on the chip 11 need to be s1, s2 and s3 respectively, s1 represents the rubbing distance of the printer-side terminals 32 corresponding to the first line of connect terminals on the chip 11, s2 represents the rubbing distance of the printer-side terminals 32 corresponding to the clock terminal 113 on the chip 11, and s3 represents the rubbing distance of the printer-side terminals 32 corresponding to the reset terminal 112 on the chip 11. Because of the provision of the hollow portion 133, the contact stroke between the printer-side terminal 32 corresponding to the power supply terminal 116, the reset terminal 112, and the ground terminal 117 and the chip 11 becomes shorter, which effectively reduces the wear of the printer-side terminals 32, avoids the contact failure and the problem of the electrical transmission between the chip 11 and the printer caused by the wear of the printer-side terminals 32, and improves the stability and reliability of the use of the chip 11 and the printer.

The chip for inkjet printer provided by the present technical solution has the following advantages over the printer chip 11 in the prior art:
Firstly, the power supply terminal 116 provided on the chip 11 is used to take power from the printer and supply it to the memory 141 of the chip 11, and the first attachment detection contact portion 115c and the second attachment detection contact 119c used for attachment detection are provided on the front end side of the power supply terminal 116 (in the installation direction P of the chip 11), which may avoid that the power supply terminal 116 will not be in contact with the printer-side terminal 32 in a case of the first attachment detection terminal 115 and the second attachment detection terminal 119 are not in contact with the power supply terminal 116, even if when the position of the printer-side terminals 32 is misaligned, which prevents the situations that the chip 11 could not be recognized or the chip 11 is damaged due to the connection between the power supply terminal 116 and the printer-side terminal 32 before the attachment detection is not completed;
secondly, the setting of the hollow portion 133 shortens the contact stroke between the printer-side terminals 32 and the chip 11, reduces the wear of the printer-side terminals 32, avoids the problem of the contact failure and the problem of the electrical transmission between the chip 11 and the printer caused by the wear of the printer-side terminals 32;
finally, at least one attachment detection contact portion is located on the front end side of the clock terminal 113, the reset terminal 112, the first series contact terminal 111 and the second series contact terminal 114 (in the installation direction P of the chip 11), and the attachment detection terminals are mutually far away from the connect terminals, thus a short circuit between the attachment detection terminal and the above connect terminals can be avoided, and the attachment detection terminals will be in contact with the printer-side terminals 32 merely after the detection of the clock terminal 113, the reset terminal 112, the first series-connected terminal 111 and the second series-connected terminal 114 are ensured to be completed, which effectively ensure the stability and the reliability of the use of the chip 11.

At last, the following description should be made: the above embodiments are merely used to illustrate the technical solutions of the present invention, rather than limit the same; although the present invention has been described in detail with reference to the foregoing embodiments, those skilled in the art should understand that it is still possible to modify the technical solutions described in the foregoing embodiments or equivalently replace some or all of the technical features therein; and these modifications or replacements do not deviate the essence of the corresponding technical solutions from the range of the technical solutions of the embodiments of the present invention.

## Claims

1. A chip (11) of inkjet printer, comprising at least a hollow portion (133), a memory (141), two attachment detection terminals (115, 119) and a power supply terminal (116) connected to the memory (141), wherein
attachment detection contact portions (115c, 119c) for making electrical contact with corresponding printer-side terminals of the printer are formed on the attachment detection terminals (115, 119), a power supply contact portion (116c) for making electrical contact with a corresponding printer-side terminal of the printer is formed on the power supply terminal (116), the power supply contact portion (116c) is provided on an end surface of the hollow portion (133), and the attachment detection contact portions (115c, 119c) are provided on both sides of the hollow portion (133), the distance between the attachment detection contact portions (115c, 119c) and a front end of the chip (11) is less than the distance between the power supply contact portion (116c) and the front end of the chip (11), in an attachment direction of installing the chip (11) to the printer.

2. The chip (11) for inkjet printer according to claim 1, wherein the power supply contact portion (116c) is provided on a rear end surface of the hollow portion (133), in the installation direction of installing the chip (11) to the printer.

3. The chip (11) for inkjet printer according to claim 2, wherein, the distance between the attachment detection contact portions (115c, 119c) and the front end of the chip (11) is less than the distance between the power supply terminal (116) and the front end of the chip (11), in the installation direction of installing the chip (11) to the printer.

4. The chip (11) for inkjet printer according to claim 3, wherein the distance between the attachment detection terminal (115, 119) and the front end of the chip (11) is less than the distance between the power supply terminal (116) and the front end of the chip (11), in the installation direction of installing the chip (11) to the printer.

5. The chip (11) for inkjet printer according to claim 1, further comprising: a ground terminal (117) and a data terminal (118) connected to the memory (141), a ground contact portion (117c) for making electrical contact with a corresponding printer-side terminal of the printer is formed on the ground terminal (117), a data contact portion (118c) for making electrical contact with a corresponding printer-side terminal of the printer is formed on the data terminal (118), at least one of the ground terminal (117) and the data terminal (118) is provided on the rear end surface of the hollow portion (133), in the installation direction of installing the chip (11) to the printer.

6. The chip (11) for inkjet printer according to claim 5, wherein the area, where the power supply contact portion (116c), the ground contact portion (117c) and the data contact portion (118c) are located, is located at the rear ends of the area where the two attachment detection contact portions (115c, 119c) are located, in the installation direction of installing the chip (11) to the printer, when both of the ground terminal (117) and the data terminal (118) are provided on the rear end surface of the hollow portion (133).

7. The chip (11) for inkjet printer according to claim 6, wherein the area, where the power supply terminal (116), the ground terminal (117) and the data terminal (118) are located, is located at the rear ends of the area where the two attachment detection terminals (115, 119) are located, in the installation direction of installing the chip (11) to the printer.

8. The chip (11) for inkjet printer according to claim 1 or 5, further comprising at least one control terminal connected with the memory (141), a control contact portion for making electrical contact with a corresponding printer-side terminal of the printer is formed on each control terminal, and the distance between the each control contact portion and the front end of the chip (11) is more than the distance between the power supply contact portion (116c) and the front end of the chip (11).

9. The chip (11) for inkjet printer according to claim 8, wherein a first short circuit detection terminal (121) and a second short circuit detection terminal (122) located between the two attachment detection terminals (115, 119) are further provided on the chip (11), both the power supply terminal (116) and the at least one control terminal are provided between the first short circuit detection terminal (121) and the second short circuit detection terminal (122).

10. The chip (11) for inkjet printer according to claim 9, wherein respective contact portions of all terminals of the chip (11) are arranged in at least three lines from the front end to the rear end of the chip (11), and the respective contact portions of all terminals arranged in at least three lines is disposed staggered in a direction perpendicular to the installation direction of installing the chip (11) to the printer.

11. The chip (11) for inkjet printer according to claim 10, wherein in the at least three lines, the front two lines from the front end side to the rear end side in the installation direction are the first line and the second line respectively, and the attachment detection contact portions (115c, 119c) are located in the first line, and the power supply contact portion (116c) is located in the second line.

12. The chip (11) for inkjet printer according to claim 8, wherein positioning portions (131, 132) recessed toward the inside of the chip (11) are formed on the chip (11), the positioning portions (131, 132) are located on both sides of rear end of the at least one control terminal.

13. The chip (11) for inkjet printer according to claim 1 or 5, wherein the hollow portion (133) is a closed structure formed inside the chip (11), or the hollow portion (133) is an opening structure formed at the front end of the chip (11).

14. An ink cartridge, **characterized in that**, the chip (11) according to any one of claims 1-13 is mounted on the ink cartridge.

15. An inkjet printer, comprising the chip (11) according to any one of claims 1-13.

## Patentansprüche

1. Chip (11) für einen Tintenstrahldrucker, der mindestens einen hohlen Abschnitt (133), einen Speicher (141), zwei Befestigungserfassungsanschlüsse (115, 119) und einen mit dem Speicher (141) verbundenen Stromversorgungsanschluss (116) umfasst, wobei
Befestigungserfassungskontaktabschnitte (115c, 119c) zum Herstellen eines elektrischen Kontakts mit entsprechenden druckerseitigen Anschlüssen des Druckers an den Befestigungserfassungsanschlüssen (115, 119) ausgebildet sind, ein Stromversorgungskontaktabschnitt (116c) zum Herstellen eines elektrischen Kontakts mit einem entsprechenden druckerseitigen Anschluss des Druckers an dem Stromversorgungsanschluss (116) ausgebildet ist, der Stromversorgungskontaktabschnitt (116c) an einer Endfläche des hohlen Abschnitts (133) vorgesehen ist, und die Befestigungserfassungskontaktabschnitte (115c, 119c) auf beiden Seiten des hohlen Abschnitts (133) vorgesehen sind, wobei der Abstand zwischen den Befestigungserfassungskontaktabschnitten (115c, 119c) und einem vorderen Ende des Chips (11) geringer ist als der Abstand zwischen dem Stromversorgungskontaktabschnitt (116c) und dem vorderen Ende des Chips (11) in der Einbaurichtung des Chips (11) in den Drucker.

2. Chip (11) für einen Tintenstrahldrucker nach Anspruch 1, wobei der Stromversorgungskontaktabschnitt (116c) an einer hinteren Endfläche des hohlen Abschnitts (133) in der Einbaurichtung des Chips (11) in den Drucker vorgesehen ist.

3. Chip (11) für einen Tintenstrahldrucker nach Anspruch 2, wobei der Abstand zwischen den Befestigungserfassungskontaktabschnitten (115c, 119c) und dem vorderen Ende des Chips (11) geringer ist als der Abstand zwischen dem Stromversorgungsanschluss (116) und dem vorderen Ende des Chips (11) in der Einbaurichtung des Chips (11) in den Drucker.

4. Chip (11) für einen Tintenstrahldrucker nach Anspruch 3, wobei der Abstand zwischen dem Befestigungserfassungsanschluss (115, 119) und dem vorderen Ende des Chips (11) geringer ist als der Abstand zwischen dem Stromversorgungsanschluss (116) und dem vorderen Ende des Chips (11) in der Einbaurichtung des Chips (11) in den Drucker.

5. Chip (11) für einen Tintenstrahldrucker nach Anspruch 1, ferner umfassend: einen Erdungsanschluss (117) und einen Datenanschluss (118), die mit dem Speicher (141) verbunden sind, wobei ein Erdungskontaktabschnitt (117c) zum Herstellen eines elektrischen Kontakts mit einem entsprechenden druckerseitigen Anschluss des Druckers an dem Erdungsanschluss (117) ausgebildet ist, ein Datenkontaktabschnitt (118c) zum Herstellen eines elektrischen Kontakts mit einem entsprechenden druckerseitigen Anschluss des Druckers an dem Datenanschluss (118) ausgebildet ist, und der Erdungsanschluss (117) und/oder der Datenanschluss (118) an der hinteren Endfläche des hohlen Abschnitts (133) in der Einbaurichtung des Chips (11) in den Drucker vorgesehen ist.

6. Chip (11) für einen Tintenstrahldrucker nach Anspruch 5, wobei der Bereich, in dem sich der Stromversorgungskontaktabschnitt (116c), der Erdungskontaktabschnitt (117c) und der Datenkontaktabschnitt (118c) befinden, an den hinteren Enden des Bereichs liegt, in dem sich die beiden Befestigungserfassungskontaktabschnitte (115c, 119c) befinden, und zwar in der Einbaurichtung des Chips (11) in den Drucker, wenn sowohl der Erdungsanschluss (117) als auch der Datenanschluss (118) an der hinteren Endfläche des hohlen Abschnitts (133) vorgesehen sind.

7. Chip (11) für einen Tintenstrahldrucker nach Anspruch 6, wobei sich der Bereich, in dem sich der Stromversorgungsanschluss (116), der Erdungsanschluss (117) und der Datenanschluss (118) befinden, an den hinteren Enden des Bereichs befindet, in dem sich die beiden Befestigungserfassungsanschlüsse (115, 119) befinden, und zwar in der Einbaurichtung des Chips (11) in den Drucker.

8. Chip (11) für einen Tintenstrahldrucker nach Anspruch 1 oder 5, der ferner mindestens einen mit dem Speicher (141) verbundenen Steueranschluss umfasst, wobei an jedem Steueranschluss ein Steuerkontaktabschnitt zur Herstellung eines elektrischen Kontakts mit einem entsprechenden druckerseitigen Anschluss des Druckers ausgebildet ist und der Abstand zwischen jedem Steuerkontaktabschnitt und dem vorderen Ende des Chips (11) größer ist als der Abstand zwischen dem Stromversorgungskontaktabschnitt (116c) und dem vorderen Ende des Chips (11).

9. Chip (11) für einen Tintenstrahldrucker nach Anspruch 8, wobei ein erster Kurzschlusserfassungsanschluss (121) und ein zweiter Kurzschlusserfassungsanschluss (122), die sich zwischen den beiden Befestigungserfassungsanschlüssen (115, 119) befinden, auf dem Chip (11) vorgesehen sind, wobei sowohl der Stromversorgungsanschluss (116) als auch der mindestens eine Steueranschluss zwischen dem ersten Kurzschlusserfassungsanschluss (121) und dem zweiten Kurzschlusserfassungsanschluss (122) vorgesehen sind.

10. Chip (11) für einen Tintenstrahldrucker nach Anspruch 9, wobei die jeweiligen Kontaktabschnitte aller Anschlüsse des Chips (11) in mindestens drei Zeilen vom vorderen Ende zum hinteren Ende des Chips (11) angeordnet sind und die jeweiligen Kontaktabschnitte aller Anschlüsse, die in mindestens drei Zeilen angeordnet sind, in einer Richtung senkrecht zur Einbaurichtung des Chips (11) in den Drucker gestaffelt sind.

11. Chip (11) für einen Tintenstrahldrucker nach Anspruch 10, wobei in den mindestens drei Zeilen die vorderen zwei Zeilen von der vorderen Endseite zur hinteren Endseite in der Einbaurichtung die erste Zeile bzw. die zweite Zeile sind, und die Befestigungserfassungskontaktabschnitte (115c, 119c) in der ersten Zeile angeordnet sind und der Stromversorgungskontaktabschnitt (116c) in der zweiten Zeile angeordnet ist.

12. Chip (11) für einen Tintenstrahldrucker nach Anspruch 8, wobei Positionierungsabschnitte (131, 132), die in Richtung der Innenseite des Chips (11) vertieft sind, auf dem Chip (11) ausgebildet sind, wobei die Positionierungsabschnitte (131, 132) auf beiden Seiten des hinteren Endes des mindestens einen Steueranschlusses angeordnet sind.

13. Chip (11) für einen Tintenstrahldrucker nach Anspruch 1 oder 5, wobei der hohle Abschnitt (133) eine geschlossene Struktur ist, die innerhalb des Chips (11) ausgebildet ist, oder der hohle Abschnitt (133) eine Öffnungsstruktur ist, die am vorderen Ende des Chips (11) ausgebildet ist.

14. Tintenpatrone, **dadurch gekennzeichnet, dass** der Chip (11) nach einem der Ansprüche 1-13 auf der Tintenpatrone montiert ist.

15. Tintenstrahldrucker, der den Chip (11) nach einem der Ansprüche 1-13 enthält.

## Revendications

1. Puce (11) d'imprimante à jet d'encre, comprenant au moins une partie creuse (133), une mémoire (141), deux bornes de détection de raccordement (115, 119) et une borne d'alimentation électrique (116) connectée à la mémoire (141), en ce que des parties de contact de détection de raccordement (115c, 119c) destinées à établir un contact électrique avec des bornes côté imprimante correspondantes de l'imprimante sont formées sur les bornes de détection de raccordement (115, 119), une partie de contact d'alimentation électrique (116c) destinée à établir un contact électrique avec une borne côté imprimante correspondante de l'imprimante est formée sur la borne d'alimentation électrique (116), la partie de contact d'alimentation électrique (116c) est ménagée sur une surface d'extrémité de la partie creuse (133), et les parties de contact de détection de raccordement (115c, 119c) sont ménagées sur les deux côtés de la partie creuse (133), la distance entre les parties de contact de détection de raccordement (115c, 119c) et une extrémité avant de la puce (11) est inférieure à la distance entre la partie de contact d'alimentation électrique (116c) et l'extrémité avant de la puce (11), dans un sens de raccordement d'installation de la puce (11) sur l'imprimante.

2. Puce (11) d'imprimante à jet d'encre selon la revendication 1, en ce que la partie de contact d'alimentation électrique (116c) est ménagée sur une surface d'extrémité arrière de la partie creuse (133), dans le sens d'installation de la puce (11) sur l'imprimante.

3. Puce (11) d'imprimante à jet d'encre selon la revendication 2, en ce que la distance entre les parties de contact de détection de raccordement (115c, 119c) et l'extrémité avant de la puce (11) est inférieure à la distance entre la borne d'alimentation électrique (116) et l'extrémité avant de la puce (11), dans le sens d'installation de la puce (11) sur l'imprimante.

4. Puce (11) d'imprimante à jet d'encre selon la revendication 3, en ce que la distance entre la borne de détection de raccordement (115, 119) et l'extrémité avant de la puce (11) est inférieure à la distance entre la borne d'alimentation électrique (116) et l'extrémité avant de la puce (11), dans le sens d'installation de la puce (11) sur l'imprimante.

5. Puce (11) d'imprimante à jet d'encre selon la revendication 1, comprenant en outre : une borne de terre (117) et un terminal de données (118) connectés à la mémoire (141), une partie de contact à la terre (117c) pour établir un contact électrique avec une borne côté imprimante correspondante de l'imprimante est formée sur la borne de terre (117), une partie de contact de données (118c) pour établir un contact électrique avec une borne côté imprimante correspondante de l'imprimante est formée sur le terminal de données (118), la borne de terre (117) et/ou le terminal de données (118) est ménagé sur la surface d'extrémité arrière de la partie creuse (133), dans le sens d'installation de la puce (11) sur l'imprimante.

6. Puce (11) d'imprimante à jet d'encre selon la revendication 5, en ce que la zone, dans laquelle se trouvent la partie de contact d'alimentation électrique (116c), la partie de contact à la terre (117c) et la partie de contact de données (118c), se trouve aux extrémités arrière de la zone dans laquelle se trouvent les deux parties de contact de détection de raccordement (115c, 119c), dans le sens d'installation de la puce (11) sur l'imprimante, lorsque la borne de terre (117) et le terminal de données (118) sont tous les deux ménagés sur la surface d'extrémité arrière de la partie creuse (133).

7. Puce (11) d'imprimante à jet d'encre selon la revendication 6, en ce que la zone, dans laquelle se trouvent la borne d'alimentation électrique (116), la borne de terre (117) et le terminal de données (118), se trouve aux extrémités arrière de la zone dans laquelle se trouvent les deux bornes de détection de raccordement (115, 119), dans le sens d'installation de la puce (11) sur l'imprimante.

8. Puce (11) d'imprimante à jet d'encre selon la revendication 1 ou 5, comprenant en outre au moins une borne de commande connectée à la mémoire (141), une partie de contact de commande pour établir un contact électrique avec une borne côté imprimante correspondante de l'imprimante est formée sur chaque borne de commande, et la distance entre chaque partie de contact de commande et l'extrémité avant de la puce (11) est supérieure à la distance entre la partie de contact d'alimentation électrique (116c) et l'extrémité avant de la puce (11).

9. Puce (11) d'imprimante à jet d'encre selon la revendication 8, en ce qu'une première borne de détection de court-circuit (121) et une seconde borne de détection de court-circuit (122) situées entre les bornes de détection de raccordement (115, 119) sont en outre ménagées sur la puce (11), à la fois la borne d'alimentation électrique (116) et au moins une borne de commande sont ménagées entre la première borne de détection de court-circuit (121) et la seconde borne de détection de court-circuit (122).

10. Puce (11) d'imprimante à jet d'encre selon la revendication 9, en ce que des parties de contact respectives de toutes les bornes de la puce (11) sont disposées dans au moins trois lignes de l'extrémité avant à l'extrémité arrière de la puce (11), et les parties de contact respectives de toutes les bornes disposées dans au moins trois lignes sont disposées en quinconce dans un sens perpendiculaire au sens d'installation de la puce (11) sur l'imprimante.

11. Puce (11) d'imprimante à jet d'encre selon la revendication 10, en ce que dans les trois lignes au moins, les deux lignes avant du côté d'extrémité avant au côté d'extrémité arrière dans le sens d'installation sont respectivement la première ligne et la deuxième ligne, et les parties de contact de détection de raccordement (115c, 119c) sont situées dans la première ligne, et la partie de contact d'alimentation électrique (116c) est située dans la deuxième ligne.

12. Puce (11) d'imprimante à jet d'encre selon la revendication 8, en ce que des parties de positionnement (131, 132) en retrait vers l'intérieur de la puce (11) sont formées sur la puce (11), les parties de positionnement (131, 132) sont situées sur les deux côtés de l'extrémité arrière d'au moins une borne de commande.

13. Puce (11) d'imprimante à jet d'encre selon la revendication 1 ou 5, en ce que la partie creuse (133) est une structure fermée formée à l'intérieur de la puce (11), ou la partie creuse (133) est une structure ouverte formée sur l'extrémité avant de la puce (11).

14. Cartouche d'encre, **caractérisée en ce que** la puce (11) selon l'une des revendications 1 à 13 est montée sur la cartouche d'encre.

15. Imprimante à jet d'encre, comprenant la puce (11) selon l'une des revendications 1 à 13.
